# EUROPÄISCHE PATENTSCHRIFT

(11) **EP 2 594 850 B1**
(45) Veröffentlichungstag und Bekanntmachung des Hinweises auf die Patenterteilung: **12.04.2017**
(21) Anmeldenummer: 12191731.4
(22) Anmeldetag: 08.11.2012
(51) Int. Cl.: F24C 7/08, A47L 15/42, B60K 37/06, D06F 39/00, G01D 5/26, G05G 1/08, G05G 1/10, H01H 25/00, H03K 17/965, G01D 5/34, H03K 17/968

(54) **Bedieneinrichtung für ein Haushaltsgerät sowie Haushaltsgerät mit einer derartigen Bedieneinrichtung**
Operating device for a domestic appliance and domestic appliance with such an operating device
Dispositif de commande pour un appareil ménager et appareil ménager doté d'un tel dispositif de commande

(30) Priorität: 18.11.2011 DE 102011086649
(43) Veröffentlichungstag der Anmeldung: 22.05.2013
(73) Patentinhaber: BSH Hausgeräte GmbH, 81739 München (DE)
(72) Erfinder: Huber, Johann, 83334 Inzell (DE); Marbach, Andreas, 83374 Traunwalchen (DE); Schemmerer, Roman, 83349 Palling (DE); Wurnitsch, Ernst, 6382 Kirchdorf in Tirol (AT)

(56) Entgegenhaltungen:
- EP-A1- 0 282 817
- EP-A2- 2 182 636
- DE-A1- 10 314 315
- DE-A1-102008 033 772
- DE-U1-202005 019 978
- JP-A- 2011 044 251

## Beschreibung

Die Erfindung betrifft eine Bedieneinrichtung für ein Haushaltsgerät, mit einer Bedienelementaufnahme und einem Bedienelement, welches drehbar auf der Bedienelementaufnahme angeordnet ist, und abhängig von der Relativposition des Bedienelements zur Bedienelementaufnahme zur Einstellung von Betriebsbedingungen des Haushaltsgeräts ausgebildet ist.

Des Weiteren betrifft die Erfindung ein Haushaltsgerät mit einer derartigen Bedieneinrichtung.

Aus dem Stand der Technik sind Bedieneinrichtungen für Kochfelder bekannt, bei denen ein Bedienelement drehbar angeordnet ist. Abhängig von der Drehbewegung kann eine Kochzone ausgewählt werden und/oder eine Kochstufe der ausgewählten Kochzone eingestellt werden. Derartige Bedieneinrichtungen basieren auf dem Prinzip der Positionsdetektion des Bedienelements, wobei dazu magnetisch oder elektromagnetisch arbeitende Sensoren eingesetzt werden.

Diese sind einerseits teuer, andererseits mit einer gewissen Detektionstoleranz einhergehend, so dass eine präzise Positionsdetektion und damit eine präzise Betriebsbedingungseinstellung begrenzt ist.

Die DE 10 2008 033 772 A1 offenbart eine Waage mit einem Bedienmittel.

Die JP 2011-044251 A offenbart eine drehbare Steuervorrichtung.

Die DE 20 2005 019 978 U1 offenbart eine Bedienvorrichtung für ein Elektrogerät.

Die DE 103 14 315 A1 offenbart ein Bedienelement.

Die EP 2 182 636 A2 offenbart eine Bedienvorrichtung für ein Hausgerät.

Die EP 0 282 817 A1 offenbart eine Wählvorrichtung.

Es ist Aufgabe der vorliegenden Erfindung, eine Bedieneinrichtung für ein Haushaltsgerät sowie ein derartiges Haushaltsgerät zu schaffen, bei dem die Positionsdetektion äußerst präzise erfolgen kann.

Diese Aufgabe wird durch eine Bedieneinrichtung und ein Haushaltsgerät gemäß den unabhängigen Ansprüchen gelöst.

Eine erfindungsgemäße Bedieneinrichtung für ein Haushaltsgerät umfasst eine Bedienelementaufnahme und ein Bedienelement, welches drehbar auf der Bedienelementaufnahme angeordnet ist. Abhängig von der Relativposition des Bedienelements zur Bedienelementaufnahme ist eine Einstellung von Betriebsbedingungen des Haushaltsgeräts ausgebildet. Die Bedieneinrichtung umfasst eine optisch arbeitende Sende-/Empfangsvorrichtung, mit welcher die Relativposition des Bedienelements erfassbar ist. Durch eine derartige Ausgestaltung kann eine kostengünstigere Sensorik im Hinblick auf die Positionsdetektion des Bedienelements geschaffen werden und darüber hinaus eine höhere Präzision in dieser Positionsdetektion erreicht werden. Durch die optisch arbeitende Sende-/Empfangsvorrichtung kann auch eine verschleißfreie Ausführung geschaffen werden.

Die Bedienelementaufnahme weist ein Podest auf, welches eine zentrale Erhebung umfasst, wobei eine komplementär ausgebildete Vertiefung im Boden des Bedienelements zur Aufnahme der Erhebung im auf dem Podest positionierten Zustand des Bedienelements ausgebildet ist. Das Bedienelement ist somit einerseits sehr verschiebesicher positioniert und kann andererseits sehr leichtgängig um seine Achse gedreht werden.

Das Podest weist eine durchgängige Aussparung auf, durch welche die optische Sende-/Empfangsvorrichtung den Boden des Bedienelements erfasst. Durch diese Ausgestaltung kann auch eine sehr platzsparende Realisierung geschaffen werden. Darüber hinaus kann durch die Aussparung ein sehr definierter Richtkanal geschaffen werden, so dass eine unerwünscht starke Lichtstreuung vermieden werden kann. Die Präzisionsdetektion der Drehstellung des Bedienelements, insbesondere mit den scharf voneinander durch unterschiedliche Strukturierung abgegrenzten Bereichen des Bodens des Bedienelements, kann somit verbessert werden.

Es ist vorgesehen, dass das Bedienelement einen strukturierten Boden aufweist, und die Sende-/Empfangsvorrichtung zur optischen Erfassung des Bodens angeordnet ist, wobei ein Strukturbereich des Bodens einer Betriebsbedingung funktionell zugeordnet ist. Eine derartige Ausgestaltung ist dahingehend besonders vorteilhaft, da das übrige Bedienelement gerade dort, wo es von einem Nutzer eingesehen werden kann, nicht unterschiedlich strukturiert werden muss und diesbezüglich auch keine ästhetischen Einbußen hingenommen werden müssen. Darüber hinaus ist durch eine derartige Detektion am Boden ein möglichst geringer Lichtverlust einhergehend, so dass ein besonders präzise optische Detektion erreicht werden kann.

Es ist vorgesehen, dass der Boden farblich und/oder in der Oberflächenrauhigkeit unterschiedlich strukturiert ist. Dies ermöglicht einerseits eine sehr einfache, robuste und im Hinblick auf Detektionssicherheit sehr hervorzuhebende Ausgestaltung.

Vorzugsweise ist vorgesehen, dass die Strukturbereiche als kuchenstückartige Kreissegmente ausgebildet sind. Die Detektionspräzision kann dadurch besonders vorteilhaft erzielt werden. Darüber hinaus sind diese kuchenstückartigen Kreissegemente im Hinblick auf ihre unterschiedliche Strukturierung einfach zu generieren und voneinander abzugrenzen.

Vorzugsweise ist das Bedienelement als zerstörungsfrei reversibel abnehmbares und wieder aufsetzbares Bedienelement ausgebildet, so dass es zu Reinigungszwecken oder dergleichen einfachst gehandhabt werden kann.

Vorzugsweise ist vorgesehen, dass zumindest das Podest der Bedienelementaufnahme eine metallische Oberfläche aufweist. Gerade in Verbindung mit der optischen Sende-/Empfangsvorrichtung kann eine derartige Kombination geschaffen werden, so dass hier keinerlei unerwünschte Reibung oder Beschädigung der metallischen Oberfläche gegeben ist.

Gerade dann, wenn das Podest eine metallische Oberfläche aufweist ist es besonders vorteilhaft durch die Aussparung zu detektieren. Besonders hervorzuheben ist hier, dass somit eine Ausgestaltung erreicht ist, bei der optisch quasi durch ein metallisches Element die Position des Bedienelements detektiert werden kann.

Obwohl sich das Bedienelement und die Sende-/Empfangsvorrichtung auf gegenüberliegenden Seite dieses metallischen Elements befinden, ist eine kurzwegige und sichere Detektion möglich. Ferner wird dadurch auch erreicht, dass bei abgenommenem Bedienelement eine gesamte metallische Oberfläche ausgebildet und sichtbar ist. Dies ist nicht nur im Hinblick auf einen qualitativ hochwertigen Eindruck zu erwähnen. Das metallische Element zur Erzeugung der metallischen Oberfläche kann eine Beschichtung oder ein separates Bauteil sein.

Vorzugsweise ist vorgesehen, dass die Aussparung zumindest bereichsweise, insbesondere vollständig mit lichtdurchlässiger Füllmasse, insbesondere Kunststoff, gefüllt ist. Dadurch kann gerade am oberen Bereich, auf dem das Bedienelement noch aufliegt, ein bündiger Übergang zu der metallischen Oberfläche geschaffen werden, so dass auch hier keinerlei unerwünschte Reibungen oder Scheuerung entsteht. Vorzugsweise ist vorgesehen, dass sich die Aussparung zur Oberseite des Podestes hin verjüngend ausbildet. Die oben bereits angesprochene optische Bündelung ist dadurch einhergehend und verbessert.

Es kann durch diese Ausgestaltung der Bedieneinrichtung mit einer optischen Sende-/Empfangsvorrichtung auch eine Beleuchtung des Bedienelements zusätzlich zu der optischen technischen Positionsdetektion erreicht werden.

Ein erfindungsgemäßes Haushaltsgerät umfasst zumindest eine erfindungsgemäße Bedieneinrichtung oder eine vorteilhafte Ausgestaltung davon. Insbesondere ist das Haushaltsgerät als Kochfeld ausgebildet und die Sende-/Empfangsvorrichtung ist unter der Kochfeldplatte angeordnet.

Es kann auch vorgesehen sein, dass das Haushaltsgerät zwei oder mehrere Bedieneinrichtungen gemäß der Erfindung aufweist.

Vorzugsweise ist vorgesehen, dass zumindest der Bereich des Podestes, welcher die Aussparung aufweist, auf der Kochfeldplatte angeordnet ist.

Ein Ausführungsbeispiel der Erfindung wird nachfolgend anhand schematischer Zeichnungen näher erläutert. Es zeigen:
- Fig. 1: eine schematische perspektivische Darstellung eines Ausführungsbeispiels eines als Kochfeld ausgebildeten Haushaltsgeräts;
- Fig. 2: eine Schnittdarstellung des Kochfelds im Bereich der Bedieneinrichtung; und
- Fig. 3: eine perspektivische Darstellung des Bedienelements von unten.

In den Figuren werden gleiche oder funktionsgleiche Elemente mit den gleichen Bezugszeichen versehen.

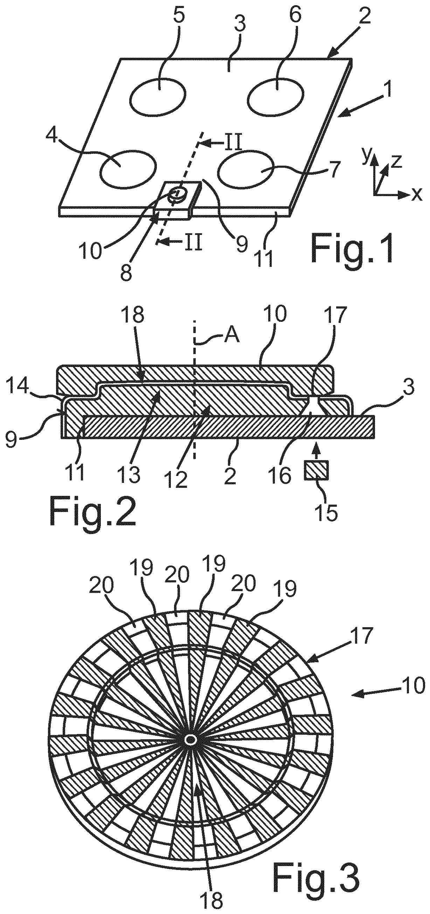

In Fig. 1 ist in einer perspektivischen Darstellung ein als Haushaltsgerät ausgebildetes Kochfeld 1 gezeigt. Dieses umfasst eine Kochfeldplatte 2, welche aus Glas oder Glaskeramik ausgebildet sein kann. Auf einer Oberseite 3 der Kochfeldplatte 2 sind in Position und Anzahl lediglich beispielhaft Kochzonen 4, 5, 6 und 7 ausgebildet. Auf die diesbezüglich gekennzeichneten und begrenzten Flächenbereiche können Zubereitungsgefäße zum Zubereiten von darin eingebrachtem Gargut aufgestellt werden. Unter der Kochfeldplatte 2 sind dazu nicht gezeigte Heizeinheiten angeordnet, mittels denen die Kochzonen 4 bis 7 beheizt werden können. Das Kochfeld 1 umfasst darüber hinaus eine Bedieneinrichtung 8, welche eine Bedienelementaufnahme 9 aufweist. Auf diese Bedienelementaufnahme 9 ist ein Bedienelement 10 zerstörungsfrei reversibel positionierbar und wieder abnehmbar angeordnet.

Das Bedienelement 10 ist im Ausführungsbeispiel scheibenförmig gestaltet. Zur weiteren Erläuterung wird auf die Fig. 2 bis Fig. 3 verwiesen. In Fig. 2 ist diesbezüglich eine Schnittdarstellung entlang der Schnittlinie II-II in Fig. 1 gezeigt. Die Schnittebene ist somit in der y-z-Ebene.

Wie zu erkennen ist, ist auf der Oberseite 3 der Kochfeldplatte 2 die Bedienelementaufnahme 9 positioniert, wobei diese darüber hinaus über einen vorderen Rand 11 der Kochfeldplatte 2 übersteht und diesen frontseitig zumindest teilweise bedeckt. Die Bedienelementaufnahme 9 umfasst ein Podest 12, das eine zentrale Erhebung 13 aufweist.

Im Ausführungsbeispiel ist eine Oberfläche 14 der Bedienelementaufnahme 9 aus Metall ausgebildet. Dies kann eine entsprechende Beschichtung sein, oder als separates metallisches Teil ausgebildet sein.

Wie zu erkennen ist, ist in Fig. 2 das Bedienelement 10 im auf der Bedienelementaufnahme 9 positionierten Zustand gezeigt. Es sitzt dabei auf dem Podest 12 auf. Das Bedienelement 10 ist relativ zur Bedienelementaufnahme 9 bewegbar und dazu nur um die Achse A drehbar. Abhängig von der relativen Drehstellung des Bedienelements 10 zur Bedienelementaufnahme 9 und insbesondere einer Sende-/Empfangsvorrichtung 15 der Bedieneinrichtung 8 kann die gewünschte Betriebsbedingungseinstellung erkannt werden.

Es ist dabei vorgesehen, dass die Bedienelementaufnahme 9 seitlich des Podestes 12 eine durchgängige Aussparung 16 aufweist. Das von der Sende-/Empfangsvorrichtung 15 emittierte Licht wird dann nach oben durch die Kochfeldplatte 2 und durch die Aussparung 16 geleitet und trifft dort auf einen Boden 17 des Bedienelements 10.

Wie aus der Darstellung in Fig. 2 zu entnehmen ist, ist der Boden 17 des Bedienelements 10 uneben ausgebildet. Er weist eine Vertiefung 18 auf, die komplementär zur Erhebung 13 gestaltet ist, so dass diese Erhebung 13 in die Vertiefung 18 eingreift, wenn das Bedienelement 10 gemäß der Darstellung in Fig. 2 auf der Bedienelementaufnahme 9 positioniert ist.

Die Detektion der Position des Bedienelements 10 erfolgt über die Sende-/Empfangsvorrichtung 15, die optisch arbeitet. Es wird dabei der Boden 17 im Ausführungsbeispiel im dickeren randseitig umlaufenden Ringbereich erfasst. Wie in Fig. 2 gezeigt ist, ist die Aussparung 16 von der Kochfeldplatte 2 hin zum Bedienelement 10 sich verjüngend ausgebildet und vollständig mit einer lichtdurchlässigen Füllmasse in Form eines Kunststoffs gefüllt. Zur Drehstellungserkennung des Bedienelements 10 relativ zur Bedienelementaufnahme 9 ist der Boden 17 spezifisch strukturiert. Dazu ist in Fig. 3 ein Ausführungsbeispiel gezeigt, bei dem eine perspektivische Ansicht des Bodens 17 zu erkennen ist. Der Boden 17 weist dabei mehrere gleichförmig und gleichgroß ausgebildete Strukturbereiche 19 auf, die im Ausführungsbeispiel farblich unterschiedlich sind. Hier ist vorgesehen, dass die Strukturbereiche 19 mit einer ersten Farbgebung versehen sind, wobei die Strukturbereiche 20 mit einer dazu unterschiedlichen zweiten Farbgebung strukturiert sind. Im Beispiel sind lediglich einige der jeweiligen Strukturbereiche 19 und 20 mit den Bezugszeichen versehen, so dass die Übersichtlichkeit gewahrt bleibt.

Wie zu erkennen ist, sind die Strukturbereiche 19 und 20 im Ausführungsbeispiel kuchenstückartige Kreissegmente.

Wie in Fig. 2 zu erkennen ist, ist die metallische Ausgestaltung der Oberfläche der Bedienelementaufnahme 9 vollständig, und somit vollflächig ausgestaltet, so dass auch das Podest 12 und die Erhebung 13 eine derartige metallische Oberfläche aufweisen.

### Bezugszeichenliste

- 1: Kochfeld
- 2: Kochfeldplatte
- 3: Oberseite
- 4, 5, 6, 7: Kochzonen
- 8: Bedieneinrichtung
- 9: Bedienelementaufnahme
- 10: Bedienelement
- 11: vorderer Rand
- 12: Podest
- 13: Erhebung
- 14: Oberfläche
- 15: Sende-/Empfangsvorrichtung
- 16: Aussparung
- 17: Boden
- 18: Vertiefung
- 19, 20: Strukturbereiche

## Patentansprüche

1. Bedieneinrichtung (8) für ein Haushaltsgerät (1), mit einer Bedienelementaufnahme (9) und einem Bedienelement (10), welches drehbar auf der Bedienelementaufnahme (9) angeordnet ist, und abhängig von der Relativposition des Bedienelements (10) zur Bedienelementaufnahme (9) zur Einstellung von Betriebsbedingungen des Haushaltsgeräts (1) ausgebildet ist, wobei eine optisch arbeitende Sende-/Empfangsvorrichtung (15) ausgebildet ist, mit welcher die Relativposition des Bedienelements (10) erfassbar ist, wobei die Bedienelementaufnahme (9) ein Podest (12) aufweist, welches eine zentrale Erhebung (13) umfasst, wobei eine komplementär ausgebildete Vertiefung (18) im Boden (17) des Bedienelements (10) zur Aufnahme der Erhebung (13) im auf dem Podest (12) positionierten Zustand des Bedienelements (10) ausgebildet ist, wobei das Podest (13) eine durchgängige Aussparung (16) aufweist, durch welche die optische Sende-/Empfangsvorrichtung (15) den Boden (17) des Bedienelements (10) erfasst **dadurch gekennzeichnet, dass** das Bedienelement (10) einen strukturierten Boden (17) aufweist, und die Sende-/Empfangsvorrichtung (15) zur optischen Erfassung des Bodens (17) angeordnet ist, wobei ein Strukturbereich (19, 20) des Bodens (17) einer Betriebsbedingung funktionell zugeordnet ist, wobei der Boden (17) farblich und/oder in der Oberflächenrauhigkeit unterschiedlich strukturiert ist.

2. Bedieneinrichtung (8) nach Anspruch 1, **dadurch gekennzeichnet, dass** die Strukturbereiche (19, 20) flächenmäßig als kuchenstückartige Kreissegmente ausgebildet sind.

3. Bedieneinrichtung (8) nach einem der vorhergehenden Ansprüche, **dadurch gekennzeichnet, dass** das Podest (12) eine metallische Oberfläche (14) aufweist.

4. Bedieneinrichtung (8) nach einem der vorhergehenden Ansprüche, **dadurch gekennzeichnet, dass** die Aussparung (16) zumindest bereichsweise, insbesondere vollständig, mit Licht durchlässiger Füllmasse, insbesondere Kunststoff, gefüllt ist.

5. Bedieneinrichtung (8) nach einem der vorhergehenden Ansprüche, **dadurch gekennzeichnet, dass** die Aussparung (16) sich zur Oberseite des Podestes (12) hin verjüngend ausbildet.

6. Haushaltsgerät (1) mit zumindest einer Bedieneinrichtung (8) nach einem der vorhergehenden Ansprüche.

7. Haushaltsgerät nach Anspruch 6, welches als Kochfeld (1) ausgebildet ist und bei welchem die Sende-/Empfangsvorrichtung (15) unter einer Kochfeldplatte (2) angeordnet ist.

8. Haushaltsgerät (1) nach Anspruch 7, mit einer Bedieneinrichtung (8) gemäß einem der Ansprüche 7 bis 9, bei welchem zumindest der Bereich des Podestes (12), welcher die Aussparung (16) aufweist, auf der Kochfeldplatte (2) angeordnet ist.

## Claims

1. Operating facility (8) for a domestic appliance (1), with an operating element receptacle (9) and an operating element (10) which is arranged on the operating element receptacle (9) in a rotatable manner and is embodied for setting operating conditions of the domestic appliance (1) depending on the relative position of the operating element (10) with respect to the operating element receptacle (9), wherein a transmit/receive apparatus (15) working optically is embodied, with which the relative position of the operating element (10) can be detected, wherein the operating element receptacle (9) has a platform (12), which comprises a central elevation (13), wherein a complementarily embodied indentation (18) is embodied in the base (17) of the operating element (10) for receiving the elevation (13) in the state where the operating element (10) is positioned on the platform (12), wherein the platform (13) has an end-to-end recess (16), through which the optical transmit/receive apparatus (15) detects the base (17) of the operating element (10), **characterised in that** the operating element (10) has a structured base (17), and the transmit/receive apparatus (15) is arranged for the optical detection of the base (17), wherein a structure region (19, 20) of the base (17) is functionally assigned to an operating condition, wherein the base (17) is structured differently in terms of colour and/or surface roughness.

2. Operating facility (8) according to claim 1, **characterised in that** the structure regions (19, 20) are embodied in terms of area as circular segments similar to cake slices.

3. Operating facility (8) according to one of the preceding claims, **characterised in that** the platform (12) has a metallic surface (14).

4. Operating facility (8) according to one of the preceding claims, **characterised in that** the recess (16) is filled at least in regions, in particular completely, with a light-permeable filling compound, in particular plastic.

5. Operating facility (8) according to one of the preceding claims, **characterised in that** the recess (16) is embodied so as to taper towards the upper side of the platform (12).

6. Domestic appliance (1) with at least one operating facility (8) according to one of the preceding claims.

7. Domestic appliance according to claim 6, which is embodied as a hob (1) and in which the transmit/receive apparatus (15) is arranged below a hob plate (2).

8. Domestic appliance (1) according to claim 7, with an operating facility (8) according to one of claims 7 to 9, in which at least the region of the platform (12), which has the recess (16), is arranged on the hob plate (2).

## Revendications

1. Dispositif de commande (8) pour un appareil ménager (1), comprenant un logement d'élément de commande (9) et un élément de commande (10), lequel est disposé de manière rotative sur le logement d'élément de commande (9) et est réalisé pour le réglage de conditions de fonctionnement de l'appareil ménager (1) en fonction de la position relative de l'élément de commande (10) par rapport au logement d'élément de commande (9), un dispositif d'émission/réception (15) fonctionnant optiquement étant réalisé, à l'aide duquel la position relative de l'élément de commande (10) peut être détectée, le logement d'élément de commande (9) présentant une plate-forme (12) laquelle comprend une élévation centrale (13), un approfondissement (18) réalisé de manière complémentaire dans le fond (17) de l'élément de commande (10) étant réalisé pour le logement de l'élévation (13) à l'état de l'élément de commande (10) positionné sur la plate-forme (12), la plate-forme (13) présentant un évidement continu (16) à travers lequel le dispositif optique d'émission/réception (15) détecte le fond (17) de l'élément de commande (10), **caractérisé en ce que** l'élément de commande (10) présente un fond structuré (17) et **en ce que** le dispositif d'émission/réception (15) est disposé pour la détection optique du fond (17), une zone structurée (19, 20) du fond (17) étant attribuée de manière fonctionnelle à une condition de fonctionnement, le fond (17) étant différemment structuré quant à la couleur et/ou quant à la rugosité de surface.

2. Dispositif de commande (8) selon la revendication 1, **caractérisé en ce que** les zones structurées (19, 20) sont réalisées en surface en tant que segments de cercle similaires à des parts de gâteau.

3. Dispositif de commande (8) selon l'une quelconque des revendications précédentes, **caractérisé en ce que** la plate-forme (12) présente une surface métallique (14).

4. Dispositif de commande (8) selon l'une quelconque des revendications précédentes, **caractérisé en ce que** l'évidement (16) est rempli au moins par zones, notamment complètement, avec une masse de remplissage perméable à la lumière, notamment de la matière plastique.

5. Dispositif de commande (8) selon l'une quelconque des revendications précédentes, **caractérisé en ce que** l'évidement (16) se réalise en se rétrécissant en direction du côté supérieur de la plate-forme (12).

6. Appareil ménager (1) comprenant au moins un dispositif de commande (8) selon l'une quelconque des revendications précédentes.

7. Appareil ménager selon la revendication 6, lequel est réalisé comme table de cuisson
(1) et dans lequel le dispositif d'émission/réception (15) est disposé sous une plaque
(2) de table de cuisson.

8. Appareil ménager (1) selon la revendication 7, comprenant un dispositif de commande (8) selon l'une quelconque des revendications 7 à 9, dans lequel au moins la zone de la plate-forme (12), laquelle présente l'évidement (16), est disposée sur la plaque (2) de table de cuisson.
